# EUROPÄISCHE PATENTANMELDUNG

(11) **EP 1 511 087 A2**
(43) Veröffentlichungstag der Anmeldung: **02.03.2005**
(21) Anmeldenummer: 04090308.0
(22) Anmeldetag: 06.08.2004
(51) Int. Cl.: H01L 31/18

(54) **Beschichtungsverfahren zur Deposition und Fixierung von Partikeln auf einer Substratoberfläche und Solarzellen mit funktionellem Schichtenaufbau**

(30) Priorität: 24.08.2003 DE 10339824
(71) Anmelder: Hahn-Meitner-Institut Berlin GmbH, 14109 Berlin (DE)
(72) Erfinder: Muffler, Hans-Jürgen, 10789 Berlin (DE); Bär, Marcus, 39288 Burg (DE); Fischer, Christian-Herbert, 14169 Berlin (DE); Rahne, Kari, 10785 Berlin (DE); Hilgendorff, Michael, 53639 Königswinter (DE); Lauermann, Iver, 14163 Berlin (DE); Lux-Steiner, Martha Christina, 14163 Berlin (DE)

(57) **Zusammenfassung**

Bekannte Beschichtungsverfahren zur Deposition von Partikeln arbeiten aus der gasförmigen oder flüssigen Phase. Nachteilig sind hier die hohen Prozesstemperaturen und die relativ hohen und schwankenden Schichtstärken. Insbesondere poröse Substratoberflächen können nur unbefriedigend beschichtet werden. Mit dem bekannten ILGAR-Verfahren können dünne, schwer lösliche Chalkogenidbeschichtungen flächendeckend auch auf sehr poröse Substrate ohne hohe Prozesstemperaturen aufgebracht werden. Bei dem erfindungsgemäßen Beschichtungsverfahren wird ausgehend von dem bekannten ILGAR-Verfahren eine partikelhaltige Lösung hergestellt, in die neben der metallischen Ausgangskomponente noch unlösliche Partikel eingebracht sind. Nach dem Auftragen der partikelhaltigen Lösung auf die Substratoberfläche sind die Partikel homogen auf der gesamten Substratoberfläche verteilt und werden im anschließenden Begasungsschritt dauerhaft in die gebildete, insbesondere oxidische Chalkogenidmatrix eingebettet. Durch die Wahl der einzubettenden Partikelsorte können die physikalischen Eigenschaften der hergestellten Chalkogenidschicht beeinflusst werden. Insbesondere durch die Wahl fluoreszierender Partikel können Fensterschichten für Solarzellen, auch in Dünnschichtausführung, konzipiert werden, die durch Umwandlung von UV-Licht in sichtbares Licht deren Konversionsgrad bedeutend erhöhen.

## Beschreibung

Die vorliegende Erfindung bezieht sich auf ein Beschichtungsverfahren zur Deposition und Fixierung von Partikeln auf einer Substratoberfläche und auf Solarzellen mit funktionellem Schichtenaufbau.

Die Modifikation technischer Oberflächen durch Beschichtung mit Partikeln ist allgemein bekannt und Gegenstand intensiver Untersuchungen. Dabei ist zu unterscheiden, ob die Partikel bereits fertig vorliegen oder zunächst in einem Syntheseschritt hergestellt und dann deponiert werden. Beides ist sowohl aus der Gasphase als auch aus einer Lösung heraus möglich. Sputterverfahren (vergleiche DE 3809734 C1) und chemische Dampfdeposition (CVD) zählen zu den Depositionsverfahren mit Gasphase, mit denen insbesondere auch dünne Schichten herstellbar sind. Bei der Deposition aus der flüssigen Phase heraus wird in der Regel ein Kolloid eingesetzt, in dem die Partikel homogen verteilt in einem Schwebezustand vorliegen. Eine Vermischung des Kolloids mit einem Lösungsmittel, das die Partikel nicht zersetzt, zu einer kolloidalen Lösung ist möglich, ohne dass die homogene Verteilung der Partikel aufgehoben wird. Eine Methode der Kolloiddeposition stellt die direkte Synthese der Partikel auf einer Substratoberfläche über Elektrodeposition, chemische Badabscheidung oder reine Adsorption der Partikel dar, bei der die kolloidale Lösung einfach auf die Substratoberfläche aufgetragen wird (vergleiche **Veröffentlichung I** von S. Papp et al.: "Growth of Pd nanoparticles on layer silicates hydrophobized with alkyl chaines in ethanoltetrahydrofuran mixtures" (Colloid Polym Sci (2002) 280: 956-962) und **Veröffentlichung II** von H. Bönnemann et al.: "Nanoscopic Metal Particles ― Synthetic Methods and Potential Applications" (Eur. J. Inorg. Chem. 2001, 2455-2480)). Nachteilig bei diesen Methoden ist es, dass sie jeweils nur eine Monolage an Partikeln auf der Substratoberfläche deponieren. Zudem ist bei der einfachen Adsorption die Haftung des Materials problematisch. Dies gilt insbesondere dann, wenn die aufgebrachten Partikel durch einen Temperschritt modifiziert werden müssen, was relativ häufig der Fall ist. Hier besteht die Gefahr der Agglomeration der Partikel, da keine Matrix besteht, in der sie eingebettet sind.

Somit ist von der direkten Deposition der Partikel auf einer Substratoberfläche deren Einbau in ein Matrixmaterial zu unterscheiden, mit dem das Substrat beschichtet wird. Vorteil dieser Einbettung ist die verbesserte Haftfähigkeit der Partikel. Außerdem können über das Matrixmaterial zusätzliche Funktionen durch die Oberflächenbeschichtung erfüllt werden. Aus der **DE 40 16 765 A1** ist unter Anwendung der hochtemperierten CVD die simultane Abscheidung von Partikeln in einer kompakten Matrix bekannt, wobei die Partikel aus dem gleichen Material wie die Matrix oder aus einem anderen Material bestehen können. Durch eine spezielle Blenden- und Substratverfahrtechnik sollen auch ausgedehnte Substrate mit dünnen Schichten beschichtet werden. Neben den hohen Prozesstemperaturen ergeben sich bei dieser bekannten Methode technologische Probleme bei der Umsetzung der Verfahrbewegung des Substrats, die verbunden sind mit einer schlechten Gewährleistung homogener Beschichtungen. Zum Einbau von Partikel in eine Matrix eines anderen Materials wird häufig auch der nasschemische Sol-Gel-Prozess eingesetzt, bei dem die Partikel in einem Sol aufgetragen werden, das sich auf der Substratoberfläche durch Verdunstung zu einem Gel verfestigt und die Partikel fixiert. Letztendlich werden die Partikel also in ein Aerogel eingebettet (vergleiche **Veröffentlichung II).** Die Sol-Gel-Methode fixiert die Partikel zwar in einer Matrix und verhindert somit deren Agglomeration bei einem Temperschritt, hat aber gravierende Nachteile. Hochporöse Materialien, wie sie beispielsweise bei Katalysatoren verwendet werden, werden mit dem Sol-Gel-Verfahren nur oberflächlich beschichtet, da es zu einer Deckelung der Poren kommt. Somit bleiben die Innenwände kleiner Poren unbeschichtet. Außerdem ist die Materialvielfalt deutlich eingeschränkt, da der Verfahrensablauf nicht mit beliebigen Komponenten durchgeführt werden kann. Weiterhin können nur relativ dicke Schichten aufgebracht werden.

Aus dem Stand der Technik sind verschiedene Depositionsmethoden für Verbindungen in der Dünnschichttechnologie bekannt. Die gängigsten trockenchemischen Beschichtungsmethoden für die Verbindungen (PVD, CVD, MOCVD, MBE und Sputtertechnik) kommen hauptsächlich in den Gebieten zum Einsatz, in denen sehr hohe Qualitätsanforderungen an Morphologie, Stöchiometrie und Kristallinität bestehen. Diese hohen Anforderungen sind aber für einfache Beschichtungen nicht immer zu stellen. Weiterhin machen die Notwendigkeit von Hochvakuum oder sogar Ultrahochvakuum, hohe Prozesstemperaturen und bisweilen sehr kleine Depositionsraten die Verfahren aber kostenintensiv und relativ ineffektiv. Zwar ist die Abscheidung auf glatten Substraten sehr homogen, bei rauen oder sogar porösen Oberflächen können bei derartigen Depositionsmethoden jedoch Abschattungseffekte auftreten, sodass Teile des Substrats unbeschichtet bleiben. Zudem ist die Zerstörungsfreiheit für das Substrat nicht immer gewährleistet, da hohe Prozesstemperaturen gefahren werden, und eine großflächige Abscheidung führt zu erheblichen technologischen Herausforderungen. Kostengünstige Alternativen hierzu sind die schon erwähnten nasschemischen Depositionsmethoden. Hier kann auf Vakuum und hohe Prozesstemperaturen verzichtet werden und zudem ist kein großer apparativer Aufwand erforderlich. Das nasschemische Beschichten (CBD) kann in einem oder mehreren Prozessschritten erfolgen, führt jedoch aufgrund schon geringer Schwankungen in den Prozessparametern (Temperatur und pH-Wert) zu Agglomeraten, die sich auf dem Substrat anlagern und die Homogenität und die physikalischen Eigenschaften des abgeschiedenen Films beeinträchtigen können. Auch die Dicke der Beschichtung, welche über die Konzentration und das Stoffmengenverhältnis der Ausgangssubstanzen sowie über die Abscheidezeit einzustellen ist, wird durch Schwankungen stark beeinflusst. Weiterhin ergeben sich technologische Probleme für eine kommerzielle Fertigung. Bei einem sequenziellen nasschemischen Verfahren (SILAR Successive Ion Layer Adsorption Reaction) wird die Ausbildung von Agglomeraten zwar verringert und der Ausnutzungsgrad der eingesetzten Materialien verbessert, es ist aber ebenfalls nur bedingt in ein Fließband integrierbar. Weiterhin ist eine gleichmäßige Beschichtung eines sehr feinporigen Substrats nur bedingt gewährleistet.

Gerade die Zielsetzung einer kompletten Beschichtung von Porenwänden, auch von sehr feinen Poren, führte zu der Entwicklung eines weiteren Abscheideverfahrens (ILGAR Ion Layer Gas Reaction, vergleiche **DE 198 31 214 C2** für chalkogenidische Oberflächenbeschichtungen und **DE 199 16 403 C1** für oxidische, keramische und metallische Oberflächenbeschichtungen). Bei diesem Verfahren wird zunächst in einem ersten Schritt eine Verbindung auf dem Substrat abgeschieden, die das Kation des gewünschten Endprodukts enthält. Typischerweise handelt es sich hierbei um ein Metallsalz. Um Abschattungseffekte auf rauen oder sogar porösen Substraten zu vermeiden, sind diese Salze in einem Lösungsmittel gelöst. Durch Eintauchen und Herausziehen des Substrats aus der Lösung (dip-Verfahren) oder durch Aufsprühen der Lösung wird das Metallsalz auf die Substratoberfläche aufgebracht. In einem zweiten Prozessschritt trocknet der Metallsalzfilm in einem Inertgasstrom (entfällt bei glatten, unporösen Substraten). In einem letzten Prozess- und dem eigentlichen Reaktionsschritt wird das Ausgangssalz mit einem das Anion des Endprodukts liefernden Reaktantgas begast und zum gewünschten Endprodukt, dem Metallchalkogenid, umgewandelt. Es handelt sich also um eine chemische Reaktion zwischen einem Feststoff und einem Gas. Das ILGAR-Verfahren ist ebenfalls ein sequenzielles Verfahren, was eine vollständige Materialausnutzung ermöglicht, jedoch das Ausbilden von Agglomeraten vollständig vermeidet. Als zyklisches Verfahren wird die Schichtdicke über die Zahl der Wiederholungen der Prozessschritte eingestellt. Da das das Anion liefernde Edukt gasförmig ist, findet die Reaktion selbst noch in stark verengten Poren statt. Weiterhin können durch die Verwendung von Gemischen in der Ausgangslösung und im Reaktantgas dünne Schichten aus Verbindungsgemischen hergestellt werden. Hierbei kann es sich auch um binäre und multinäre Verbindungshalbleiter handeln. Das ILGAR-Verfahren bietet somit auch die Möglichkeit, direkt auf die optischen und elektrischen Eigenschaften der abgeschiedenen Dünnschichten Einfluss zu nehmen. Die einzige Bedingung an das Reaktionsprodukt besteht darin, dass es wegen des zyklischen Verlaufs des Herstellungsprozesses in der Ausgangslösung unlöslich sein muss. Da dies bei geeigneter Wahl des Lösungsmittels für sehr viele Verbindungen der Fall ist, eröffnet sich ein weites Spektrum an Anwendungsmöglichkeiten. Das ILGAR-Verfahren ist mittlerweile in der Fachwelt gut etabliert und umfassend beschrieben. Zusammenfassend bestehen seine markantesten Vorteile in der Kostengünstigkeit, der vollständigen Materialausnutzung, dem Wegfall von Vakuumbedingungen, der niedrigen Prozesstemperatur typischerweise im Bereich der Raumtemperatur, die eine Verwendung auch von Kunststoffsubstraten ermöglicht, die homogene, der Oberfläche des Substrats folgende Abscheidung, sodass auch Substrate mit beliebiger Oberflächenmorphologie, also auch mit sehr kleinen Poren, eingesetzt werden können, sowie die Einstellung der Stöchiometrie über das Stoffmengenverhältnis der Ausgangsverbindungen zueinander und die leichte Automatisierbarkeit des Verfahrens. Diese Vorteile machen das ILGAR-Verfahren zu einem äußerst attraktiven Beschichtungsverfahren, dessen Einsatz sich für eine Vielzahl von Anwendungsfällen anbietet und somit anzustreben ist.

Ausgehend von den bekannten Beschichtungsverfahren ist es daher die **Aufgabe** für die vorliegende Erfindung, ein Verfahren zur Deposition und Fixierung von Partikeln auf einer Substratoberfläche anzugeben, mit dem auch poröse Substrate zuverlässig und homogen sowie kostengünstig und großtechnisch mit einer partikelhaltigen Dünnschicht beschichtet werden können. Dabei sollen vielfältige Materialkombinationen und verschiedene Substrate eingesetzt werden können. Die erfindungsgemäße **Lösung** für diese Aufgabe ist dem Hauptanspruch zu entnehmen. Vorteilhafte Weiterbildung der Erfindung sind den Unteransprüchen zu entnehmen, die im Folgenden im Zusammenhang mit der Erfindung näher erläutert werden. Weiterhin werden in Nebenansprüchen Solarzellen unterschiedlichen Aufbaus beansprucht, die partikelhaltige, insbesondere mit dem Beschichtungsverfahren nach der Erfindung hergestellte Schichten enthalten. Auch hier sind vorteilhafte Weiterbildungen den entsprechenden Unteransprüchen zu entnehmen.

Bei dem erfindungsgemäßen Beschichtungsverfahren wird eine Fixierung der Partikel mit dem ILGAR-Verfahren auf einer Substratoberfläche beliebiger Morphologie vorgenommen. Somit können alle Vorteile des ILGAR-Verfahrens auf das erfindungsgemäße Beschichtungsverfahren übernommen werden. Hinzu kommt bei der Erfindung noch, dass die Partikel über ihre Einbettung in die Chalkogenidmatrix sicher auf der Substratoberfläche haften, homogen verteilt sind und an der Agglomeration gehindert werden. Da die Partikel weder im Beschichtungsverfahren selbst generiert werden noch an einer chemischen Reaktion beteiligt sind, können Partikel unterschiedlichster Materialien und Größen in Rein- oder Mischform verwendet werden. Wichtig bei der Verwendung der Partikel ist, dass sie in der eingesetzten Ausgangslösung unlöslich sind und sich in dieser homogen verteilen und nicht am Boden des Aufbewahrungsgefäßes absetzen. Partikeldurchmesser von mehreren Mikrometern bis hin zu wenigen Nanometern sind möglich, es können monodisperse (nur ein Partikeldurchmesser) oder multidisperse Mischungen eingesetzt werden. Im Zusammenhang mit porösen Substraten ist der Durchmesser der eingesetzten Partikel in Abhängigkeit vom Porendurchmesser so zu wählen, dass eine durchgängige Beschichtung auch in den Porenoberflächen gewährleistet ist. Bei den eingesetzten Partikeln kann es sich um Metallpartikel und Partikel aus unlöslichen anorganischen, aber auch organischen Verbindungen handeln. Deren Herstellung ist bekannt, zum Teil sind die Partikel in Form von kolloidalen Suspensionen kommerziell erhältlich. Besonders vorteilhaft ist bei dem erfindungsgemäßen Beschichtungsverfahren also durch die weitgehend freie Wahl der beteiligten Materialien (sowohl der Chalkogenidmatrix als auch der Partikel) die genaue Einstellbarkeit der physikalischen und chemischen Eigenschaften der hergestellten Beschichtung. Dadurch kann diese ganz unterschiedliche funktionelle Eigenschaften aufweisen (siehe unten). Generell kann das Beschichtungsverfahren nach der Erfindung neben großtechnischen Verwendungsgebieten auch in der Nanotechnologie seine Anwendung finden. Im Speziellen ist das Verfahren und die damit hergestellte Dünnschicht aber auch in der Solartechnologie anwendbar. Hier können zusätzliche funktionelle Schichten auf eine Solarzelle aufgebracht werden, sowie speziell bei Dünnschichtsolarzellen einzelne Schichten durch eine mit dem Verfahren nach der Erfindung hergestellte partikelhaltige Dünnschicht ersetzt werden, sodass durch die geschickte Materialauswahl und Einstellung des Stoffmengenverhältnisses von Partikel zu Matrix die elektronischen und optischen Eigenschaften der Schicht günstiger beeinflusst werden können.

Die Chalkogenidmatrix wird bei dem erfindungsgemäßen Beschichtungsverfahren über das ILGAR-Verfahren bereitgestellt. Partikel, deren Größe bis in den Mikrometerbereich reichen kann, und Chalkogenidmatrix werden simultan abgeschieden. Dies wird gewährleistet, indem zur Ausgangslösung des ILGAR-Verfahrens die Partikel als Pulver oder in kolloidaler Aufbereitung hinzugegeben werden, sodass sich eine partikelhaltige Lösung ergibt. Bei Verwendung von Partikel mit einer Größe im Nanometerbereich entsteht entsprechend eine kolloidale Lösung. Das verwendete Lösungsmittel ist so gewählt, dass es die Metallverbindung, in der Regel handelt es sich hierbei um ein Metallsalz, löst, nicht jedoch die Partikel. Sind die Metallverbindung und die Partikel innerhalb der Lösung gut vermischt, so ist sicher gewährleistet, dass im Verfahrensschritt des Aufbringens der partikelhaltigen Lösung auf die Substratoberfläche die deponierte Schicht ebenfalls aus einem homogenen Gemisch besteht. Eine hier möglicherweise bereits einsetzende Agglomeration der Partikel wird verhindert, weil das Lösungsmittel rasch verdampft. Die trockene und feste Precursorschicht wird dann im eigentlichen Reaktionsschritt durch Begasen mit einem chalkogenwasserstoffhaltigen Gas als Reaktantgas derart modifiziert, dass die ausgehende Metallverbindung, das Ausgangssalz, zum gewünschten Endprodukt chemisch umgewandelt wird. Hierbei werden die Partikel jedoch im günstigen Fall nicht an der Reaktion mit dem Reaktantgas beteiligt. Die Partikel sind nach dem Begasungsschritt in homogener Verteilung in der entstandenen Chalkogenidmatrix fixiert und lassen sich auch nicht mehr bei eventuell darauffolgenden Spülschritten bzw. beim nächsten Eintauchen des Substrats in die partikelhaltige Ausgangslösung aus dieser herauslösen. Auch erforderliche Temperschritte, die bei einer Oxidmatrix zur Entwässerung und generell zum Wachstum der Kristallite führen, führen zu keiner Agglomeration der Teilchen.

Im Folgenden sollen einzelne funktionelle Ausprägungen der herstellbaren Beschichtungen im Zusammenhang mit dem gewählten Materialsystem näher erläutert werden. Bei der Verwendung von Metallpartikeln (Durchmesser im nm-Bereich), beispielsweise Au, Ag, Fe, in einer oxidischen, halbleitenden Chalkogenidschicht (die Verwendung einer sulfidischen Chalkogenidschicht könnte hier zu einer Sulfurisierung der Partikel führen), kann eine Erhöhung der makroskopischen Leitfähigkeit erreicht werden. Gleiches gilt für die Verwendung von Graphitpartikeln mit Durchmessern im µm- bis nm-Bereich. Werden ferromagnetische Partikel, wie beispielsweise Kobaltpartikel, in einer Chalkogenidmatrix aus Zinkoxid, aber auch in anderen oxidischen Halbleiterschichten eingesetzt, können makroskopische, ferroelektrische Dünnschichten hergestellt werden. Durch Einlagerung von katalytisch wirksamen Partikeln, beispielsweise Pt-Partikeln, in bevorzugt oxidische ILGAR-Schichten können katalytische Schichten erzeugt werden. Weiterhin können spezielle optische Eigenschaften der Partikel in den funktionellen Schichten ihre Anwendung finden.

Bei der Verwendung von optisch absorbierenden Partikeln, die allerdings alle den gleichen Durchmesser haben müssen (monodisperses Kolloid), und der Verwendung einer Kristallstruktur der Matrix, die nicht konform zur Kristallstruktur des Partikels ist, kann die Phonon-Photon-Kopplung in der hergestellten Schicht unterdrückt werden. Daher ergibt sich im Absorptionsverhalten der hergestellten Schicht eine scharfe, steil ansteigende Absorptionskante. Optische Filter stellen für eine derartige Schicht ein mögliches Anwendungsgebiet dar. Weiterhin können auch multidisperse Kolloide als optisch fluoreszierende Partikeln verwendet werden. Auch hier darf die Kristallstruktur der Matrix nicht konform mit der Kristallstruktur des Kolloids sein, sodass sich wieder eine Unterdrückung der Phonon-Photon-Kopplung ergibt. Bei fluoreszierenden Partikel wird dadurch ein enger Frequenzbereich des fluoreszierenden Lichts hervorgerufen. In der Anwendung können solche Schichten eingesetzt werden, um ungünstige Absorptionsbereiche optischer Bauteile zu kompensieren. Dies geschieht, indem Licht einer Photonenergie größer als die zu meidende Absorptionskante über Fluoreszenz in Licht kleinerer Photonenenergie als diese Kante umgewandelt wird. Interessant werden diese Schichten bei Solarzellen. Hier kann UV-Licht in sichtbares Licht umgewandelt werden, was zu einer höheren Konversionsrate des Lichts zu elektrischem Strom führt. Dies gilt generell für alle Solarzellen. Im Speziellen sei hier die Chalkopyrit-Dünnschichtsolarzelle aufgeführt. Diese besitzt eine im UV-Bereich absorbierende Fensterschicht, welche den Wellenlängenbereich des Lichts fast vollständig absorbiert, sodass er nicht mehr der eigentlichen Absorberschicht zukommt. Die Folge ist ein Stromverlust, der bislang in Kauf genommen werden musste (siehe hierzu auch speziellen Beschreibungsteil). Weiterhin zeigen derartige Partikelschichten auch noch einen Anti-Reflexions-Effekt, der auftretende Interferenzen der Lichtstrahlung vollständig unterdrückt. Vorteil der Verwendung von insbesondere Kolloiden als fluoreszierende Partikel ist also die bewirkte Einstellung ihres Absorptions- und Fluoreszenzbereiches über die Partikelgröße (Größenquantisierungseffekt). Möglich ist daher auch ein Multilayersystem aus Partikelschichten mit Partikeln zunehmender Größe. Dadurch kann erreicht werden, dass der Fluoreszenzbereich der oberen Partikelschicht genau der Absorptionsbereich der darunterliegenden Partikelschicht ist. Es kommt zu einer Fluoreszenz-Absorptions-Kaskade, bis Licht generiert ist, welches ein Optimum an Photostrom in der Solarzelle zur Folge hat. Im Organischen findet dies beispielsweise bei Pflanzen mit unterschiedlich großem Chlorophyll statt.

Neben den genannten Partikeln zur Veränderung der elektrischen, magnetischen und optischen Eigenschaften können auch Partikel zur Beeinflussung anderer Eigenschaften eingesetzt werden. Beispielsweise kann es sich hierbei um Kunststoffpartikel handeln, die in einem entsprechenden Polymerkolloid eingesetzt werden. Diese können in beliebige ILGAR-Schichten eingesetzt werden, deren Schmelzpunkt allerdings oberhalb des verwendeten Kunststoffs liegen muss. Nach Beendigung des Beschichtungsprozesses können dann die Kunststoffpartikel herausgeschmolzen werden, sodass eine entsprechend homogene, mikro- bis nanoporöse dünne Beschichtung entsteht. Mögliche Anwendungsgebiete sind hier die Herstellung von Filtern und die Membrantechnologie. Weiterhin können Farbpigmente in eine transparente ILGAR-Matrix eingebettet werden, um eine Erhöhung der Kratzfestigkeit von Farbschichten durch die schwerlösliche, ultraharte ILGAR-Beschichtung zu erreichen. Generell kann durch den Partikelzusatz in der ILGAR-Beschichtung noch eine Erhöhung der Oberflächenfestigkeit und der Oberflächenrauigkeit erreicht werden. Schließlich kann durch einen Zusatz von Partikeln aus dem gleichen Material wie die ILGAR-Matrix (Chalkogenid-Kolloid, Chalkogenid-Matrix) ein schnelleres Wachstum von dickeren ILGAR-Schichten erreicht werden, da die materialidentischen Partikel als Wachstumskeime dienen.

Das erfindungsgemäße Beschichtungsverfahren basiert auf dem bekannten ILGAR-Verfahren, mit dem in einfacher Weise ohne eine hohe Prozesstemperatur, wie sie beispielsweise beim Pyrolyseverfahren zur Einleitung einer chemischen Reaktion erforderlich ist, dünne, schwer lösliche chalkogenidische, oxidische, keramische und metallische Schichten auf Substraten mit beliebiger Oberflächenmorphologie, insbesondere auch poröse Substrate, aufgebracht werden können. Das ILGAR-Verfahren in seinen möglichen Ausführungsformen ist aus den beiden deutschen Patenten **DE198 31 214 C2** und **DE 199 16 403 C1** bekannt und soll hier nicht weiter erläutert werden. Es soll aber an dieser Stelle darauf hingewiesen werden, dass alle im Zusammenhang mit dem ILGAR-Verfahren gemachten Aussagen und genannten Vorteile auch im Zusammenhang mit der vorliegenden Erfindung gelten. Diese ist in einer Vielzahl unterschiedlicher Ausführungsformen realisierbar. Ihr besonderer Vorteil liegt in der nahezu freien Kombinierbarkeit der Materialsysteme bezüglich Zusammensetzung und Ausprägung, sodass nunmehr funktionelle Beschichtungen hergestellt werden können, die in ihren physikalischen Eigenschaften optimal einstellbar sind.

Anhand von Ausführungsbeispielen soll im Folgenden der Charakter des Beschichtungsverfahrens nach der Erfindung und deren Realisierbarkeit näher verdeutlicht werden. Dabei zeigt die
- **Figur 1**: eine TEM-Aufnahme einer hergestellten partikelhaltigen Dünnschicht,
- **Figur 2**: das Ergebnis einer EDAX-Analyse.
- **Figur 3**: das XPS-Spektrum der hergestellten Dünnschicht und
- **Figur 4**: das Transmissionsverhalten einer ZnO-Fensterschicht ohne und mit fluoreszierende Partikel.

Im Folgenden wird zunächst ein Beispiel einer Synthese von CdS-Partikeln in einer ILGAR-ZnO-Matrix gegeben.

### Präparation der kolloidalen Ausgangslösung :

20 mM Cd(ClO₄) und 0,5 M C₁₂H₂₅SH wurden in 100 ml THF gelöst. Diese Lösung wurde für 5 min mit N₂ begast. Anschließend wurde unter kräftigem Schütteln 4 mM H₂S zu der Lösung gegeben. Eine stark gelbe Verfärbung der Lösung war zu beobachten, was auf die Entstehung von CdS-Partikeln in der nun kolloidalen Lösung schließen lässt. Anschließend wurden zu 10 ml der kolloidalen CdS-Lösung 90 ml THF hinzugegeben. Danach wurden 20 mM Zn(ClO₄)₂ der Lösung hinzugefügt, sodass die fertige Ausgangslösung entstand.

### ILGAR-Prozess:

Die Probe A3 wurde für 10 s in die kolloidale Ausgangslösung eingetaucht. Daraufhin wurde die nun mit dem adsorbierten Metallsalz und den Partikeln belegte Substratoberfläche in einem Ofen bei einer Prozesstemperatur von 180 °C für 45 s mit einem NH₃/H₂O-Gasgemisch begast (ILGAR-Oxidabscheidung gemäß **DE 199 16 403 C1)** und anschließend für weitere 15 s im Ofen gelassen. Im Anschluss wurde in H₂O und THF gespült. Diese Prozessschritte wurden 5mal wiederholt.

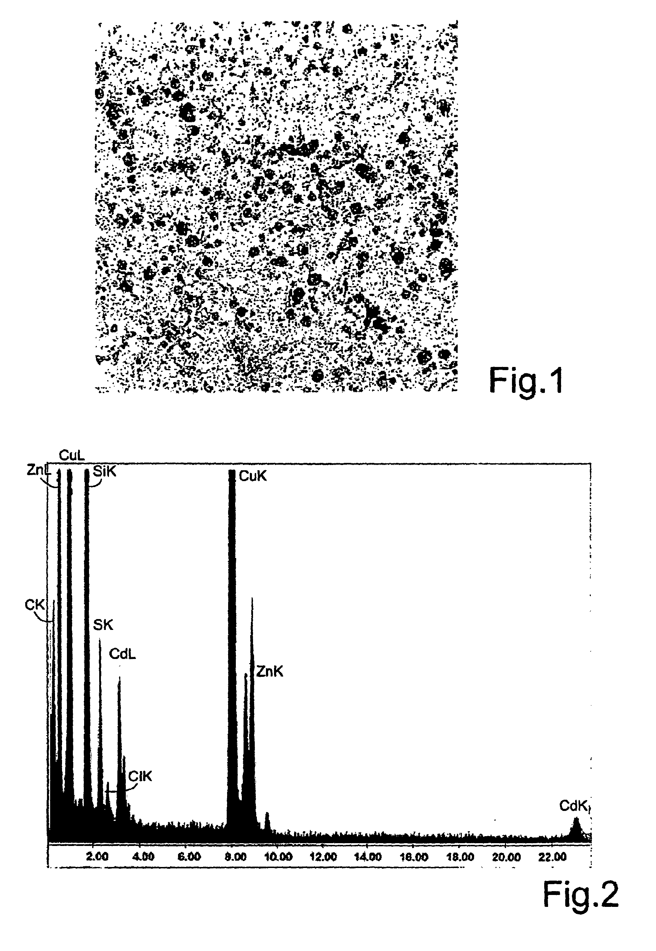

In der **Figur 1** ist eine Aufnahme der hergestellten Beschichtung auf der Probe A3 gezeigt, dass mit einem hochauflösenden Transmissionselektronenmikroskop (TEM) aufgenommen wurde. Deutlich sind die CdS-Partikel zu erkennen (dunkle Punkte), die in eine ZnO-Matrix (graue Bereiche) eingebettet sind. Zum Nachweis der Materialzusammensetzung wurde eine energiedispersive Röntgenanalyse (EDAX Energy Dispersive Analysis of X-ray) der beschichteten Probe A3 durchgeführt. Das Ergebnis ist in Figur 2 dargestellt. Gezeigt ist die Röntgenstrahlintensität über der Wellenlänge. Die Peaks zeigen für bestimmte Elemente charakteristische Röntgenstrahlenemission. Die Bezeichnung der Peaks setzt sich aus dem jeweiligen Elementkürzel und der belegten Atomschale zusammen. Neben dem Cu- und dem Si-Signal des Substrates, bei dem es sich um ein mit SiO beschichtetes Kupfergitter handelte, sind neben C deutlich die Elemente Cd, Zn, S und O zu erkennen. Bei den abgeschiedenen Verbindungen handelt es sich daher um Oxide und Sulfide.

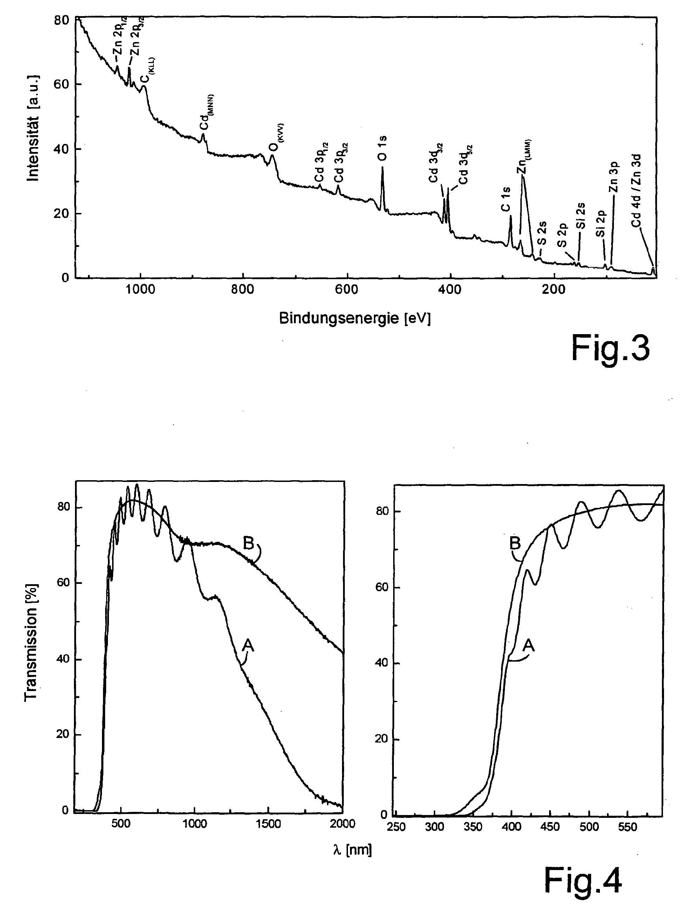

In der **Figur 3** zeigt das Übersichtsspektrum einer Photoelektron-Spektroskopie-Messung (XPS-Messung) einer zu der Probe A3 identisch prozessierten Schicht auf Silizium. Aufgetragen ist die Intensität (intensitiy) in normierter Einheit über der Bindungsenergie (binding energy) in eV. Die Bezeichnungen der Peaks setzt sich aus dem Elementkürzel und der Schalenangabe bzw. Augerübergang zusammen. Das XPS-Spektrum weist ebenfalls Signale der Elemente Cd, Zn, S und O auf. Über die energetische Position der Signale kann auf die Verbindung geschlossen werden. Mit sehr hoher Wahrscheinlichkeit handelt es sich bei der Schicht um ein Gemisch aus CdS und ZnO. Die Verbindungen CdO und ZnS können ausgeschlossen werden. Somit führte der durchgeführte ILGAR-Prozess zu keiner Umwandlung der CdS-Partikel. Eine Diffusion des Schwefels mit anschließender Bildung von ZnS aus der hergestellten ZnO-Matrix erfolgte ebenfalls nicht. Somit wurden eindeutig CdS-Partikel in eine ILGAR-ZnO-Matrix eingebettet.

In der **Figur 4** ist das Transmissionsverhalten einer ZnO-Fensterschicht (Kurve A) dargestellt. Dabei zeigt das rechte Diagramm eine Ausschnittsvergrößerung des linken Diagramm. Aufgetragen ist die Transmission in % über der Wellenlänge λ in nm. Deutlich ist die Absorptionskante bei ca. 375 nm zu erkennen, außerdem treten starke Interferenzen (Schwingungen in der Kurve A) auf. Das Aufbringen einer nach dem obigen Synthesebeispiel hergestellten, mit CdS-Partikeln dotierten ILGAR-ZnO-Schicht auf dieser Fensterschicht bewirkt eine klare Blauverschiebung der Absorptionskante (Kurve B). Zwar ist die Absorptionskante des Fensters unverändert geblieben, durch die Fluoreszenz ist jedoch ein Teil des UV-Lichts in sichtbares Licht umgewandelt worden, was die Transmission erhöht. Nebenbei hat hier die Dotierung der zusätzlichen Fensterschicht mit den Partikeln auch noch einen Anti-Reflexions-Effekt hervorgerufen, der die Interferenzen stark unterdrückt. Somit können Solarzellen konzipiert werden, die mit fluoreszierenden Partikeln enthaltene ILGAR-Schichten, die nach vorliegender Erfindung hergestellt wurden, umfassen und einen hohen Konversionsgrad aufweisen.

## Patentansprüche

1. Beschichtungsverfahren zur Deposition und Fixierung von Partikeln auf einer Substratoberfläche beliebiger Morphologie durch deren Einbau in eine Chalkogenidmatrix mit einer Abscheidung des Partikel-Matrix-Systems als schwerlösliche Dünnschicht gemäß nachstehend aufgeführten Verfahrensschritten mit einem in Abhängigkeit von der unterschiedlichen Reaktionsfähigkeit der jeweils für die Chalkogenidbildung eingesetzten Metallverbindungen unterschiedlich festgelegten Temperaturregime typischerweise im Bereich der Raumtemperatur, wobei die Verfahrensschritte vom Aufbringen der Ausgangslösung bis zum Erreichen einer gewünschten Schichtstärke zyklisch wiederholt werden, :
• Herstellen einer partikelhaltigen Ausgangslösung aus einem leichtflüchtigen Lösungsmittel, einer Metallverbindung und zumindest einer Sorte von Partikeln, die lösungsmittelresistent sind und sich in der Ausgangslösung homogen verteilen,
• Aufbringen der partikelhaltigen Ausgangslösung auf ein Substrat zur Adsorption der Metallverbindung und der Partikel auf der Substratoberfläche in homogener Verteilung ohne Eintritt einer chemischen Reaktion,
• schnelles Entziehen des Lösungsmittels aus der aufgebrachten Schicht aus Metallverbindung und Partikeln, wobei diese auf der Substratoberfläche nicht agglomerieren, und
• Einleiten eines chalkogenwasserstoffhaltigen Gases zur Reaktion mit der adsorbierten Metallverbindung unter unlösbarer Einbettung der adsorbierten Partikel, die nicht mit dem eingeleiteten Gas reagieren, in die gebildete Chalkogenidmatrix

2. Beschichtungsverfahren nach Anspruch 1,
**dadurch gekennzeichnet, dass**
nach Erreichen der gewünschten Schichtstärke ein Temperschritt zur Verbesserung der Schichteigenschaften durchgeführt wird.

3. Beschichtungsverfahren nach Anspruch 1 oder 2,
**dadurch gekennzeichnet, dass**
anschließend an jeden Verfahrenszyklus oder nach Erreichen der gewünschten Schichtstärke ein Spülschritt zur Entfernung nichtumgewandelter Reaktionsedukte und/oder unerwünschter Reaktionsnebenprodukte durchgeführt wird.

4. Beschichtungsverfahren nach einem der Ansprüche 1 bis 3,
**dadurch gekennzeichnet, dass**
das schnelle Entziehen des Lösungsmittels durch Trocknen in einem Inertgasstrom erfolgt.

5. Beschichtungsverfahren nach einem der Ansprüche 1 bis 4,
**dadurch gekennzeichnet, dass**
das Aufbringen der partikelhaltigen Ausgangslösung durch Tauchen oder Sprühen erfolgt.

6. Beschichtungsverfahren nach einem der Ansprüche 1 bis 5,
**dadurch gekennzeichnet, dass**
ein basisch wirkendes, feuchtes chalkogenwasserstoffhaltiges Gas eingesetzt und eine oxidische Chalkogenidmatrix gebildet wird.

7. Beschichtungsverfahren nach einem der Ansprüche 1 bis 6,
**dadurch gekennzeichnet, dass**
ein Metallsalz als Metallverbindung eingesetzt wird.

8. Beschichtungsverfahren nach einem der Ansprüche 1 bis 7,
**dadurch gekennzeichnet, dass**
kolloidale Partikel eingesetzt werden.

9. Beschichtungsverfahren nach einem der Ansprüche 1 bis 8,
**dadurch gekennzeichnet, dass**
Metall- und/oder Graphit-Partikel eingesetzt werden.

10. Beschichtungsverfahren nach einem der Ansprüche 1 bis 9,
**dadurch gekennzeichnet, dass**
ferromagnetische Partikel eingesetzt werden.

11. Beschichtungsverfahren nach einem der Ansprüche 1 bis 10,
**dadurch gekennzeichnet, dass**
katalytisch wirkende Partikel eingesetzt werden.

12. Beschichtungsverfahren nach einem der Ansprüche 1 bis 11,
**dadurch gekennzeichnet, dass**
optisch absorbierende Partikel eingesetzt werden.

13. Beschichtungsverfahren nach einem der Ansprüche 1 bis 12,
**dadurch gekennzeichnet, dass**
optisch fluoreszierende Partikel eingesetzt werden.

14. Beschichtungsverfahren nach einem der Ansprüche 1 bis 13,
**dadurch gekennzeichnet, dass**
Polymer-Partikel eingesetzt werden.

15. Beschichtungsverfahren nach einem der Ansprüche 1 bis 14,
**dadurch gekennzeichnet, dass**
Farbpigment-Partikel eingesetzt werden.

16. Beschichtungsverfahren nach einem der Ansprüche 1 bis 15,
**dadurch gekennzeichnet, dass**
Chalkogenid-Partikel von der Art der herzustellenden Chalkogenidmatrix eingesetzt werden.

17. Solarzelle mit einem funktionellen Schichtenaufbau,
**dadurch gekennzeichnet, dass**
eine oder mehrere Schichten mit Partikeln versehen sind, die mit dem Beschichtungsverfahren nach einem der Ansprüche 1 bis 16 hergestellt worden sind.

18. Solarzelle mit einem funktionellen Schichtenaufbau,
**dadurch gekennzeichnet, dass**
zumindest eine zusätzliche funktionale Schicht vorgesehen ist, die mit dem Beschichtungsverfahren nach einem der Ansprüche 1 bis 16 hergestellt worden ist.

19. Solarzelle nach Anspruch 17 oder 18,
**dadurch gekennzeichnet, dass**
die Schichten als Dünnschichten ausgebildet sind.

20. Solarzelle nach Anspruch 19,
**dadurch gekennzeichnet, dass**
die partikelfreien Dünnschichten mit dem ILGAR-Verfahren hergestellt worden sind.
